# FASCICULE DE BREVET EUROPEEN

(11) **EP 1 346 475 B1**
(45) Date de publication et mention de la délivrance du brevet: **18.06.2008**
(21) Numéro de dépôt: 01999041.5
(22) Date de dépôt: 29.11.2001
(51) Int. Cl.: H03G 7/06

(54) **ENSEMBLE COMMANDABLE DE SOURCES DE COURANT**
EINE VIELZAHL VON STEUERBAREN STROMQUELLEN
CONTROLLABLE SET OF CURRENT SOURCES

(30) Priorité: 30.11.2000 FR 0015522
(43) Date de publication de la demande: 24.09.2003
(73) Titulaire: STMicroelectronics S.A., 92120 Montrouge (FR)
(72) Inventeur: MOURET, Michel, F-38560 Jarrie (FR); SABUT, Marc, F-38320 Eybens (FR); VAN ZANTEN, François, F-38240 Meylan (FR)
(74) Mandataire: de Beaumont, Michel
(86) Numéro de dépôt international: PCT/FR2001/003788
(87) Numéro de publication internationale: WO 2002/045261

(56) Documents cités:
- EP-A- 0 317 758
- WO-A-00/28664
- US-A- 5 077 541

## Description

La présente invention concerne un ensemble commandable de sources de courant, et en particulier un tel ensemble commandable de sources de courant commandant un amplificateur dont le gain varie de manière exponentielle en réponse à une tension de commande analogique.

Un tel amplificateur est réalisable sous forme de circuit intégré et est par exemple utilisé comme amplificateur à balayage de gain dans un équipement de téléphonie mobile.

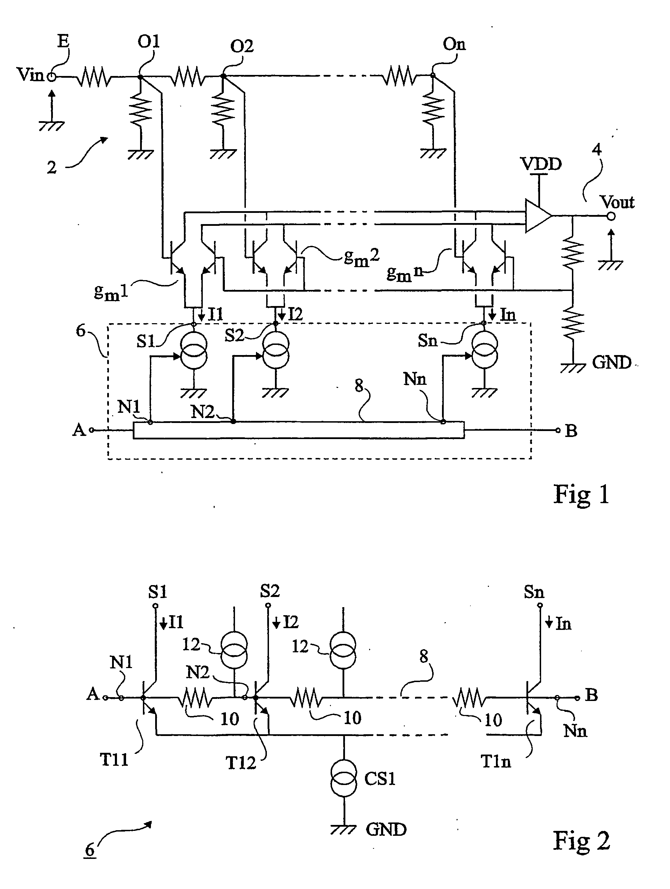

La figure 1 représente schématiquement un amplificateur classique dont le gain varie exponentiellement en réponse à une tension de commande analogique. Un tel amplificateur est décrit dans le brevet US-A-5077541. L'amplificateur comprend une borne d'entrée E recevant un potentiel d'entrée Vin variable positif. L'amplificateur comprend en outre deux bornes de commande A et B recevant une tension de commande VAB, et une borne de sortie produisant un potentiel de sortie Vout. L'amplificateur comprend un bloc atténuateur 2. Le bloc atténuateur 2 a une borne d'entrée reliée à la borne E, et n bornes de sortie Oi (i étant compris entre 1 et n). Chaque borne de sortie Oi du bloc 2 produit un potentiel de commande égal au potentiel d'entrée Vin atténué selon un rapport prédéterminé, par exemple 2ⁱ dans le cas d'un atténuateur R/2R. Chaque borne de sortie Oi du bloc 2 est associée à un élément transconducteur gₘi commandable en courant. Chaque élément transconducteur gₘi reçoit en entrée le potentiel produit par la borne Oi de même rang i. Un bloc de sortie 4, relié à un potentiel d'alimentation VDD, produit le potentiel Vout en réponse à la somme des courants fournis par les éléments transconducteurs gₘi. Le bloc de sortie 4 est également connecté pour fournir un signal de contre réaction aux éléments transconducteurs gₘi. Un ensemble commandable de sources de courant 6 comporte des sorties Si, chaque sortie Si étant connectée de manière à commander la transconductance de l'élément transconducteur gₘi de même rang i. Les bornes de commande A et B sont reliées à l'ensemble commandable de sources de courant 6.

La figure 2 représente schématiquement un ensemble commandable de sources de courant 6 classique, également décrit dans le brevet US-A-5077541. Chaque borne de sortie Si est reliée au collecteur d'un transistor bipolaire de type NPN, T1i. Les émetteurs des transistors T1i sont reliés les uns aux autres et à la masse (GND) par l'intermédiaire d'une source de courant constant CS1. La base de chaque transistor T1i est reliée à un noeud Ni d'un moyen de commande 8.

Dans le moyen de commande 8 :
le premier noeud N1 est couplé à la borne A ;
le dernier noeud Nn est couplé à la borne B ;
chaque noeud Nj (j étant compris entre 1 et n-1) est relié au noeud Nj+1 par l'intermédiaire d'une résistance 10 ; et
chaque noeud Nj (j étant compris entre 2 et n-1) est relié à une première borne d'une source de courant constant 12 propre à ce noeud.

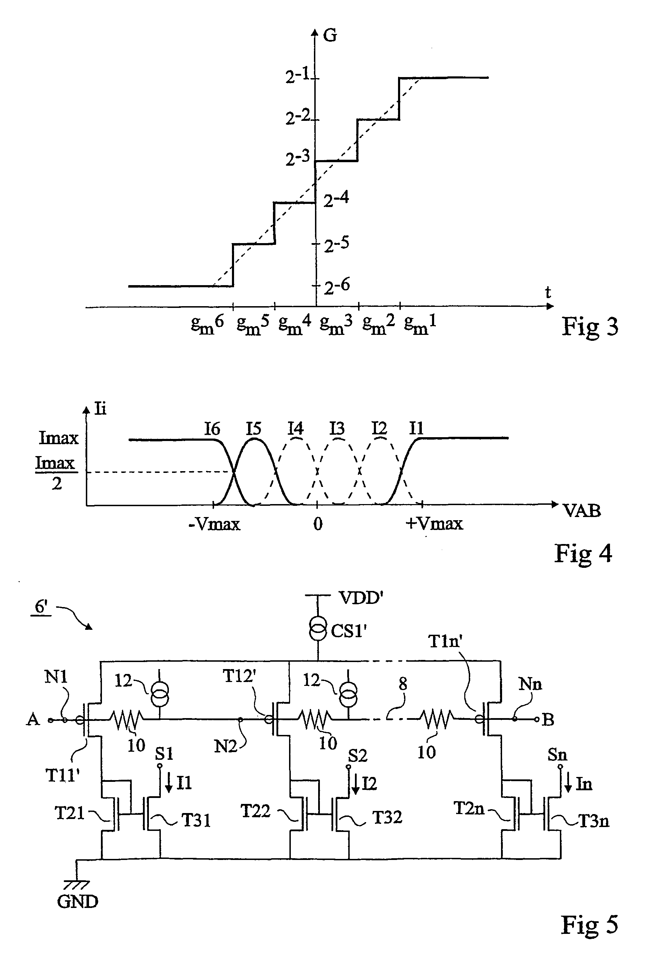

La figure 3 illustre de manière simplifiée l'évolution du gain de l'amplificateur de la figure 1 lorsque les éléments transconducteurs gₘi successifs sont activés. Dans l'exemple représenté, on considère que n = 6. Si l'on active successivement et séparément chacun des éléments transconducteurs gₘ6 à gₘ1, le bloc de sortie 4 reçoit un courant successivement proportionnel à une atténuation de rapport 2⁶, 2⁵, 2⁴, 2³, 2² et 2¹ du potentiel Vin. Le gain de l'amplificateur varie ainsi exponentiellement. L'activation en tout-ou-rien des éléments transconducteurs gₘi donne lieu à des variations brusques du gain, selon une courbe en escalier telle que la courbe représentée en traits pleins. L'ensemble de sources de courant 6 est prévu pour supprimer ces brusques variations de gain et fournir la variation de gain illustrée en pointillés en figure 3.

La figure 4 illustre schématiquement les courants de commande Ii respectivement produits par les bornes de sortie Si de l'ensemble de sources de courant 6. Le moyen de commande 8 est prévu, lorsque la tension de commande VAB décrit une plage de tension prédéterminée, pour rendre successivement chaque transistor T1i progressivement conducteur puis progressivement non conducteur tout en faisant que la somme des courants Ii traversant les transistors T1i reste sensiblement constante. On considère par la suite que le moyen de commande 8 est prévu pour que deux transistors T1i au maximum soient conducteurs à la fois. On considère que la plage de tension prédéterminée précédente est comprise entre une tension minimale -Vmax (VA = 0 et VB = Vmax), et une tension maximale +Vmax (VA = Vmax et VB = 0). Lorsque la tension VAB est minimale, les potentiels des noeuds Ni sont tels que seul le transistor T16 est conducteur. Le transistor T16 est alors traversé par un courant maximal de valeur Imax. Lorsque la tension VAB croît linéairement, le potentiel des noeuds N6, N5 évolue de façon que le transistor T16 est progressivement bloqué tandis que le transistor T15 devient progressivement conducteur. Les autres transistors T1i sont bloqués. Lorsque le transistor T15 devient complètement conducteur, il est traversé par un courant maximal de valeur Imax et le transistor T16 est bloqué. Lorsque la tension VAB continue de croître jusqu'à la valeur +Vmax, le transistor T15 est progressivement bloqué tandis que le transistor T14 est progressivement rendu conducteur, et ainsi de suite jusqu'à ce que seul le transistor T11 soit conducteur et traversé par le courant Imax.

Cependant, les sources de courant 12 du moyen de commande 8 fournissent en permanence un courant dans les bases des transistors T1i de l'ensemble de sources de courant 6. L'existence de ces courants de base rend la réalisation du moyen de commande 8 délicate, notamment pour la détermination des valeurs des résistances 10 et des sources de courant 12. De plus, ces courants de base dépendent notamment du processus de fabrication et de la température de fonctionnement. Ceci entraîne qu'une même tension de commande VAB n'aura pas le même effet sur les sources de courant 6 pour deux températures de fonctionnement différentes.

Un amplificateur à gain variable complètement différentiel recevant un signal différentiel d'entrée et produisant un signal différentiel de sortie est classiquement réalisé au moyen de deux amplificateurs identiques. Un premier amplificateur reçoit un potentiel Vin et produit en réponse un potentiel Vout, et le second amplificateur reçoit un potentiel Vin' et produit en réponse un potentiel Vout'. Les deux amplificateurs doivent être identiques pour que le signal de sortie ne soit pas distordu. Il est notamment important que les sources de courant 6 commandant chaque amplificateur soient identiques et produisent des courants de commande identiques pour une même tension de commande VAB. Or, il est difficile de réaliser deux sources de courant 6 appariées. En particulier lorsque l'amplificateur est réalisé sous forme de circuit intégré, les deux ensembles de transistors T1i peuvent être éloignés l'un de l'autre, et il est difficile de réaliser deux ensembles de transistors T1i ayant les mêmes propriétés.

En outre, la structure de l'ensemble de sources de courant 6 est telle que ses bornes de sortie Si présentent inévitablement un potentiel de fonctionnement élevé (par exemple supérieur à 2,2 V), en raison notamment du fait qu'il faut prévoir un potentiel de fonctionnement élevé (2,5 V) sur les noeuds de commande A et B du moyen 8. Il résulte de cette contrainte et de l'existence des autres circuits constitutifs de l'amplificateur de la figure 1 qu'un tel amplificateur doit être alimenté sous une tension élevée, généralement 5 V. De nombreux équipements électroniques ont une tension d'alimentation inférieure à 3 V, notamment les équipements de téléphonie mobile, et il est souhaitable de disposer d'un amplificateur à gain variable qui peut être alimenté par une tension inférieure à 3 V.

La demande de brevet PCT WO-00/28664 décrit une architecture de tuner intégrée incluant un ensemble commandable de sources de courant.

Un objet de la présente invention est de prévoir un amplificateur à gain variable ayant les mêmes fonctions que l'amplificateur de la figure 1 et qui peut être alimenté par une tension inférieure à 3 V.

Un autre objet de la présente invention est de prévoir un tel ensemble de sources de courant comprenant un moyen de commande simple à réaliser.

Un autre objet de la présente invention est de prévoir un tel ensemble de sources de courant dont la réponse à la tension de commande ne dépend pas de la température.

Un autre objet de la présente invention est de prévoir un tel ensemble de sources de courant qui puisse fournir des couples de courants de commande appariés.

Pour atteindre ces objets, ainsi que d'autres, la présente invention prévoit un ensemble commandable de sources de courant tel que défini en revendication 1.

La présente invention vise également des amplificateurs à gain variable tels que définis en revendications 3 et 4.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente schématiquement un amplificateur à gain variable classique ;
la figure 2, précédemment décrite, représente schématiquement un ensemble commandable de sources de courant classique ;
La figure 3, précédemment décrite, illustre le fonctionnement de l'amplificateur de la figure 1 ;
La figure 4, précédemment décrite, illustre le fonctionnement de l'ensemble de sources de courant de la figure 2 ;
La figure 5 représente schématiquement un ensemble commandable de sources de courant selon un premier mode de réalisation de la présente invention ;
la figure 6 représente schématiquement un ensemble commandable de sources de courant selon un deuxième mode de réalisation de la présente invention ; et
la figure 7 représente un amplificateur à gain variable utilisant l'ensemble de sources de courant de la figure 6.

De mêmes références représentent de mêmes éléments dans les différentes figures. Seuls les éléments nécessaires à la compréhension de la présente invention ont été représentés aux figures suivantes.

La figure 5 représente schématiquement un ensemble commandable de sources de courant 6' selon la présente invention. L'ensemble de sources de courant 6' comporte n bornes de sortie Si (i étant compris entre 1 et n) et deux bornes de commande A et B. Chaque borne de sortie Si est reliée au drain d'un transistor MOS T3i, à canal N. La source de chaque transistor T3i est reliée à la masse (GND). Chaque transistor T3i est associé à un transistor MOS T2i, à canal N, et à un transistor MOS T1i', à canal P. La source du transistor T2i est reliée à la masse. La grille et le drain du transistor T2i sont reliés l'un à l'autre. La grille du transistor T3i est reliée à la grille du transistor T2i, de manière que le courant traversant le transistor T3i dépend du courant traversant le transistor T2i. Le drain du transistor T2i est relié au drain du transistor T1i', de manière que ces transistors sont en série. La source du transistor T1i' est reliée à un potentiel d'alimentation VDD' par l'intermédiaire d'une source de courant constant CS1'. La grille du transistor T1i' est reliée à un noeud Ni d'un moyen de commande 8 de même structure que le moyen de commande 8 décrit en relation avec la figure 2.

Chaque borne de sortie Si fournit un courant Ii dépendant du courant traversant le transistor T1i', c'est à dire dépendant du potentiel du noeud Ni de même rang i. Le moyen de commande 8 a un fonctionnement semblable au fonctionnement décrit en relation avec la figure 4. Lorsque la tension VAB décrit une plage de tension prédéterminée, le moyen de commande 8 rend successivement chaque transistor T1i progressivement conducteur puis progressivement non conducteur, de manière que la somme des courants Ii traversant les transistors T1i' est sensiblement constante. La fonction de l'ensemble de sources de courant 6' est ainsi la même que celle de l'ensemble de sources de courant 6 précédente. Le potentiel de fonctionnement de chaque borne de sortie Si est fixé uniquement par la tension drain-source du transistor T3i lorsque ce dernier est conducteur, soit sensiblement 0,2V, et est indépendant du potentiel de commande sur les noeuds A, B du moyen 8. Un tel potentiel de fonctionnement permet de commander efficacement les éléments transconducteurs gₘi de l'amplificateur de la figure 1 même si ce dernier est alimenté sous 3 V.

En outre, les sources de courant 12 du moyen de commande 8 ne fournissent aucun courant aux grilles des transistors T1i', ce qui simplifie grandement la conception du moyen de commande 8 et supprime les problèmes de dépendance en température.

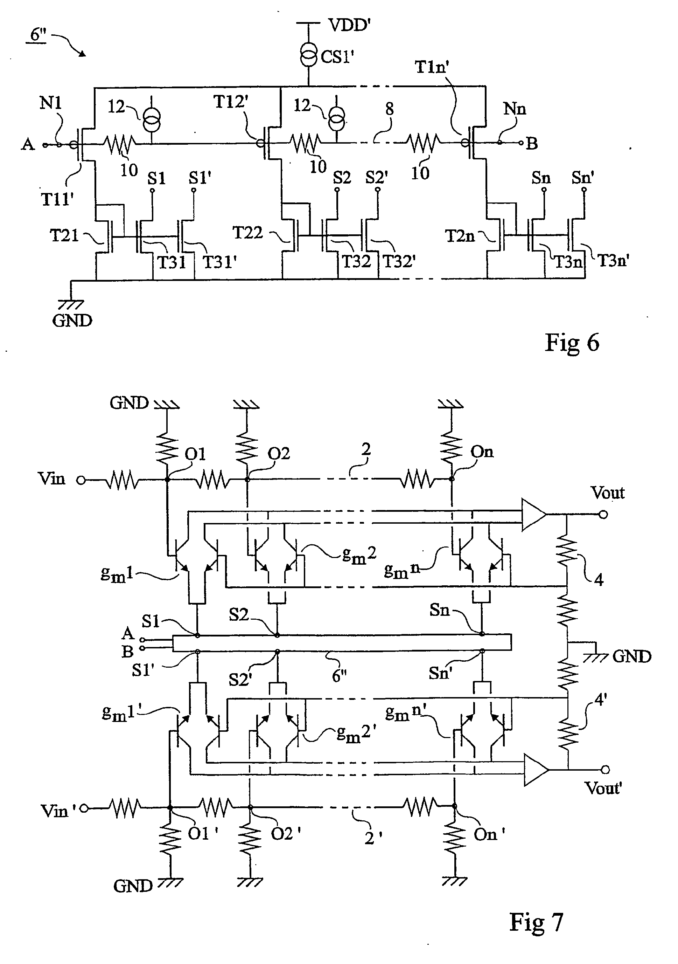

La figure 6 représente schématiquement un ensemble de sources de courant 6" selon un deuxième mode de réalisation de la présente invention. Chaque transistor T2i, au lieu d'être monté en miroir de courant avec un transistor T3i, est associé à deux transistors de duplication identiques T3i et T3i', respectivement connectés à des bornes de sortie Si et Si'. Il est simple de disposer les transistors T3i et T3i' à proximité les uns des autres dans un circuit intégré. Il est alors simple de réaliser des transistors T3i et T3i' appariés. Ceci permet de réaliser simplement un amplificateur complètement différentiel tel qu'illustré à titre d'exemple en figure 7.

La figure 7 représente schématiquement un amplificateur à gain variable destiné à recevoir une tension différentielle Vin - Vin' et à fournir en réponse une tension différentielle Vout - Vout', comprenant un amplificateur 6" tel que décrit en relation avec la figure 6. Le potentiel Vin est fourni à un bloc atténuateur 2 commandant des éléments transconducteurs gₘi. Chaque élément transconducteur gₘi est commandé en courant par la sortie Si de même rang i de l'ensemble de sources de courant 6". Les courants produits par les éléments transconducteurs gₘi sont fournis à un bloc de sortie 4, qui fournit en réponse le potentiel Vout. Le bloc de sortie 4 fournit un signal de contre-réaction aux éléments transconducteurs gₘi. Le potentiel Vin' est fourni à un bloc atténuateur 2' identique au bloc 2. Le bloc 2' commande des éléments transconducteurs gₘi', chaque élément transconducteur gₘi' étant identique à l'élément transconducteur gₘi de même rang i. Chaque élément transconducteur gₘi' est commandé en courant par la sortie Si' de même rang i de l'ensemble de sources de courant 6". Les courants produits par les éléments transconducteurs gₘi' sont fournis à un bloc de sortie 4', identique au bloc 4, qui fournit en réponse le potentiel Vout'. Le bloc de sortie 4' fournit un signal de contre-réaction aux éléments transconducteurs gₘi'.

Les blocs atténuateurs 2 et 2' forment un bloc atténuateur différentiel recevant le signal différentiel d'entrée Vin - Vin', chaque couple Oi, Oi' formant une borne de sortie différentielle du bloc atténuateur différentiel. Chaque borne de sortie différentielle Oi, Oi' du bloc atténuateur différentiel commande un couple d'éléments transconducteurs gₘi, gₘi'. Les blocs de sortie 4 et 4' forment un bloc de sortie différentiel recevant les courants fournis par les couples d'éléments transconducteurs gₘi, gₘi', et produisant en réponse le signal de sortie différentiel Vout - Vout'. Les couples d'éléments transconducteurs gₘi, gₘi' sont commandés par les couples de courants de commande appariés Ii, Ii' produits par l'ensemble de sources de courant 6".

La présente invention, qui est définie dans la revendication 1, est susceptible de diverses variantes et modifications qui apparaîtront à l'homme du métier. En particulier, on a décrit les transistors T1i' comme des transistors MOS à canal P, mais l'homme du métier adaptera sans difficultés la présente invention à des transistors T1i' MOS à canal N.

En outre, on a décrit l'ensemble de sources de courant selon la présente invention en relation avec un moyen de commande 8 particulier, commandant l'ensemble de sources de courant de manière que la somme des courants fournis par l'ensemble de sources de courant soit sensiblement constante, et que au maximum deux transistors T1i soient conducteurs en même temps, mais l'homme du métier adaptera sans difficultés la présente invention à un moyen de commande 8 différent, par exemple tel que plus de deux transistors T1i soient conducteurs en même temps.

En outre, l'ensemble de sources de courant selon la présente invention a été décrit en relation avec la commande d'un amplificateur à gain variable particulier, mais l'homme du métier adaptera sans difficultés la présente invention à la commande d'un autre type d'amplificateur, ou à toute autre application nécessitant l'utilisation d'un tel ensemble de sources de courant, par exemple un potentiomètre électronique.

## Revendications

1. Ensemble commandable de sources de courant (6', 6") comportant :
plusieurs premières bornes de sortie (Si),
un premier transistor MOS (T1i') associé à chaque première borne de sortie, le courant (Ii) sur chaque première borne de sortie dépendant du courant traversant le premier transistor,
un miroir de courant associé a chaque première borne de sortie et formé de transistors MOS (T2i, T3i), fournissant à la première borne de sortie un courant dépendant du courant traversant le premier transistor et comprenant un deuxième transistor (T2i) connecté en série avec le premier transistor (T1i'), et un troisième transistor (T3i) connecté en miroir de courant avec le deuxième transistor (T2i), le troisième transistor étant également connecté de manière que le courant (Ii) fourni par la première borne de sortie est égal au courant traversant le troisième transistor, et
un moyen de commande (8) prévu pour, en réponse à une variation prédéterminée d'une tension de commande (VAB), rendre successivement chaque premier transistor (T1i') progressivement conducteur puis progressivement non conducteur,
dans lequel :
le premier transistor (T1i') est un transistor à canal P dont la source est reliée à un premier potentiel d'alimentation (VDD') par l'intermédiaire d'une source de courant constant (CS1') et dont la grille est reliée à un noeud (Ni) du moyen de commande (8),
le deuxième transistor (T2i) est un transistor à canal N dont la source est reliée à un second potentiel d'alimentation (GND), dont la grille est reliée au drain et dont le drain est relié au drain du premier transistor,
le troisième transistor (T3i) est un transistor à canal N dont la source est reliée au second potentiel d'alimentation (GND), dont la grille est reliée à la grille du deuxième transistor et dont le drain est relié à la première borne de sortie (S1, S2...Sn).

2. Ensemble de sources de courant (6") selon la revendication 1, comprenant pour chacun des miroirs de courant un quatrième transistor (T3i') identique au troisième transistor (T3i), également connecté en miroir de courant avec le deuxième transistor (T2i), et comprenant une deuxième borne de sortie (Si') couplée au quatrième transistor de manière que la deuxième borne de sortie produise un courant (Ii') égal au courant traversant le quatrième transistor.

3. Amplificateur à gain variable comprenant :
un bloc atténuateur (2) ayant une borne d'entrée (E) recevant un potentiel d'entrée (Vin) et ayant plusieurs bornes de sortie (0i),
plusieurs éléments transconducteurs (gₘi) commandables en courant, chaque élément transconducteur ayant une entrée reliée à une borne de sortie (0i) du bloc atténuateur (2),
un ensemble de sources de courant (6') selon la revendication 1, chaque première borne de sortie (Si) de l'ensemble de sources de courant étant connectée de manière à fournir un courant de commande (Ii) à un élément transconducteur (gₘi), et
un bloc de sortie (4) fournissant un potentiel de sortie (Vout) en réponse à la somme des courants fournis par les éléments transconducteurs.

4. Amplificateur à gain variable comprenant :
un bloc atténuateur différentiel (2/2') ayant une entrée recevant un signal d'entrée différentiel (Vin - Vin') et ayant plusieurs bornes de sortie différentielles (Oi/Oi'),
plusieurs couples d'éléments transconducteurs (gₘi/gₘi') commandables en courant, chaque couple d'éléments transconducteurs ayant une entrée différentielle reliée à une borne de sortie différentielle (Oi/Oi') du bloc atténuateur (2/2'), chaque couple d'éléments transconducteurs produisant un couple de courants,
un ensemble de sources de courant (6") selon la revendication 2, dont les premières (Si) et deuxièmes (Si') bornes de sortie sont connectées de manière à commander chacune un couple d'éléments transconducteurs (gₘi/gₘi'), et
un bloc de sortie (4, 4') fournissant un signal de sortie différentiel (Vout - Vout') en réponse à la somme des couples de courants fournis par les couples d'éléments transconducteurs.

## Claims

1. A controllable assembly of current sources (6', 6") including:
several first output terminals (Si),
a first MOS transistor (T1i') associated with each first output terminal, the current (Ii) on each first output terminal depending on the current flowing through the first transistor,
a current mirror associated with each first output terminal formed of MOS transistors (T2i, T3i), providing to the first output terminal a current depending on the current flowing through the first transistor and including a second transistor (T2i) connected in series with the first transistor (T1i') and a third transistor (T3i) connected as a current mirror with the second transistor (T2i), the third transistor being also connected so that the current (Ii) provided by the first output terminal is equal to the current flowing through the third transistor, and
a control means (8) provided for, as a response to a predetermined variation of a control voltage (VAB), successively progressively turning on, then progressively turning off, each first transistor (T1i'),
wherein:
the first transistor (T1i') is a P-channel transistor having its source connected to a first supply voltage (VDD') via a constant current source (CS1') and having its gate connected to a node (Ni) of the control means (8),
the second transistor (T2i) is an N-channel transistor having its source connected to a second supply voltage (GND), having its gate and drain interconnected, and having its drain connected to the drain of the first transistor,
the third transistor (T3i) is an N-channel transistor having its source connected to the second supply voltage (GND), having its gate connected to the gate of the second transistor and having its drain connected to the first output terminal (S1, S2...Sn).

2. The current source assembly (6") of claim 1, including for each current mirror a fourth transistor (T3i') identical to the third transistor (T3i), also connected as a current mirror with the second transistor (T2i), and including a second output terminal (Si') coupled to the fourth transistor so that the second output terminal generates a current (Ii') equal to the current running through the fourth transistor.

3. A variable-gain amplifier including:
an attenuator block (2) having an input terminal (E) receiving an input voltage (Vin) and having several output terminals (Oi),
several transconductance elements (gₘi) controllable by a current, each transconductance element having an input connected to an output terminal (Oi) of the attenuator block (2),
the current source assembly (6') of claim 1, each first output terminal (Si) of the current source assembly being connected to provide a control current (Ii) to a transconductance element (gₘi), and
an output block (4) providing an output voltage (Vout) as a response to the sum of the currents provided by the transconductance elements.

4. A variable-gain amplifier including:
a differential attenuator block (2/2') having an input receiving a differential input signal (Vin-Vin') and having several differential output terminals (Oi/Oi'),
several pairs of transconductance elements (gₘi/gₘi') controllable by a current, each pair of transconductance elements having a differential input connected to a differential output terminal (Oi/Oi') of the attenuator block (2/2'), each pair of transconductance elements generating a current pair,
an assembly of current sources (6") according to claim 2, each first (Si) and second (Si') output terminals being connected to control a pair of transconductance elements (gₘi/gₘi'), and
an output block (4, 4') providing a differential output signal (Vout-Vout') as a response to the sum of the current pairs provided by the pairs of transconductance elements.

## Patentansprüche

1. Eine steuerbare Anordnung von Stromquellen (6', 6"), die Folgendes beinhaltet:
mehrere erste Ausgangsanschlüsse (Si),
einen ersten MOS Transistor (T1i'), der mit jedem ersten Ausgangsanschluss assoziiert ist, wobei der Strom (li) auf jedem ersten Ausgangsanschluss abhängt von dem Strom, der durch den ersten Transistor fließt,
einen Stromspiegel, der mit einem ersten Ausgangsanschluss assoziiert ist, der aus MOS Transistoren (T2i, T3i) gebildet ist, an den ersten Ausgangsanschluss einen Strom vorsehend, abhängig von dem Strom, der durch den ersten Transistor fließt und beinhalten eines zweiten Transistors (T2i), der in Reihe mit dem ersten Transistor (T1i') verbunden ist, und einen dritten Transistor (T3i) beinhaltend, der als ein Stromspiegel mit dem zweiten Transistor (T2i) verbunden ist, wobei der dritte Transistor auch verbunden ist, so dass der Strom (li), der durch den ersten Ausgangsanschluss vorgesehen ist, gleich dem Strom ist, der durch den dritten Transistor fließt und
ein Steuermittel (8), das vorgesehen ist für, ansprechend auf eine vorherbestimmte Variation von einer Steuerspannung (VAB), nachfolgendes progressives Einschalten, dann progressives Ausschalten jedes ersten Transistors (T1i'),
wobei:
der ersten Transistor (T1i') ein P-Kanaltransistor ist, dessen Quelle bzw. Source mit einer ersten Versorgungsspannung (VDD') über eine Konstant-Stromquelle (CS1') verbunden ist, und dessen Gatter mit einem Knoten (Ni) von dem Steuermittel (8) verbunden ist,
der zweite Transistor (T2i) ein N-Kanaltransistor ist, dessen Quelle mit einer zweiten Versorgungsspannung (GND) verbunden ist, dessen Gatter und Drain zusammengeschaltet sind, und dessen Drain mit dem Drain des ersten Transistors verbunden ist,
der dritte Transistor (T3i) ein N-Kanal-Transistor ist, dessen Quelle mit der zweiten Versorgungsspannung (GND) verbunden ist, dessen Gatter mit dem Gatter von dem zweiten Transistor verbunden ist, und dessen Drain mit dem ersten Ausgangsanschluss (S1, S2...Sn) verbunden ist.

2. Stromquellenanordnung (6") nach Anspruch 1, die für jeden Stromspiegel einen vierten Transistor (T3i') beinhaltet, der identisch dem dritten Transistor (T3i) ist, auch verbunden als ein Stromspiegel mit dem zweiten Transistor (T2i) ist und einen zweiten Ausgangsanschluss (Si') beinhaltet, der mit dem vierten Transistor derart gekoppelt ist, dass der zweite Ausgangsanschluss einen Strom (li') erzeugt, der gleich dem Strom ist, der durch den vierten Transistor fließt.

3. Ein Verstärker mit variabler Verstärkung, der Folgendes beinhaltet:
einen Dämpfungsblock (2), der einen Eingangsanschluss (E) besitzt, der eine Eingangsspannung (Vin) empfängt und der mehrere Ausgangsanschlüsse (Oi) besitzt,
mehrere Transkonduktanz-Elemente (gₘi), die durch einen Strom steuerbar sind, wobei jedes Transkonduktanz-Element einen Eingang besitzt, der mit einem Ausgangsanschluss (Oi) von dem Dämpfungsblock (2) verbunden ist,
die Stromquellenanordnung (6') nach Anspruch 1, wobei jeder erste Ausgangsanschluss (Si) von der Stromquellenanordnung verbunden ist, zum Vorsehen eines Steuerstroms (li) an ein Transkonduktanz-Element (gₘi) und
ein Ausgangsblock (4), der eine Ausgangsspannung (Vout) vorsieht, ansprechend auf die Summe von den Strömen, die durch die Transkonduktanz-Elemente vorgesehen sind.

4. Ein Verstärker mit variabler Verstärkung, der Folgendes beinhaltet:
einen Differentialdämpfungsblock (2/2'), der einen Eingang besitzt, der ein Differentialeingangssignal (Vin-Vin') empfängt und mehrere Differentialausgangsanschlüsse (Oi/Oi') besitzt,
mehrere Paare von Transkonduktanz-Elementen (gₘi/gₘi'), die durch einen Strom steuerbar sind, wobei jedes Paar von Transkonduktanz-Elementen einen Differentialeingang besitzt, der mit einem Differentialausgangsanschluss (Oi/Oi') von dem Dämpfungsblock (2/2') verbunden ist, wobei jedes Paar von Transkonduktanz-Elementen ein Strompaar erzeugt,
eine Anordnung von Stromquellen (6") gemäß Anspruch 2, wobei jede erste (Si) und zweite (Si') Ausgangsanschlüsse verbunden sind zum Steuern eines Paares von Transkonduktanz-Elementen (gₘi/gₘi') und
einen Ausgangsblock (4, 4'), der ein Differentialausgangssignal (Vout-Vout') vorsieht, ansprechend auf die Summe von den Strompaaren, die durch die Paare von Transkonduktanz-Elementen vorgesehen sind.
